# EUROPEAN PATENT APPLICATION

(11) **EP 2 500 733 A1**
(43) Date of publication of application: **19.09.2012**
(21) Application number: 11250737.1
(22) Date of filing: 24.08.2011
(51) Int. Cl.: G01R 1/067

(54) **Test probe with ceramic coating and test instrument**

(30) Priority: 18.03.2011 CN 201110066896
(71) Applicant: Milwaukee Electric Tool Corporation, Brookfield, WI 53005 (US)
(72) Inventor: Wang, Mao Chuan, Sichuan (CN); Yang, Dao Jun, Hubei (CN); Xie, Xian Yuan, Shenzhen City (CN)
(74) Representative: Stevenson-Hill, Jack Patrick

(57) **Abstract**

The present invention discloses a test probe including a conductive member having a first end defined by an electrically conductive tip, and an insulative member surrounding a first portion of the conductive member. The second potion of the conductive member between the first end and the first potion is coated with a layer of insulative material. The test probe in the present invention does not require separate probe tips to be carried for use on various test applications but still meet the safety requirement of IEC standard.

## Description

### FIELD OF INVENTION

This invention relates to a test probe on a test instrument, and in particular a test probe with insulation measures.

### BACKGROUND OF INVENTION

Test instruments, such as multimeters, voltage meters, oscilloscopes and the like, are used to measure electrical parameters in various electrical devices. A typical test instrument uses a plurality of test probes connected to input / output terminals on the body of the test instrument to measure various electrical parameters. The test probe usually has a test lead with an electrically conductive tip to contact the object that is to be measured.

In general, different test lead tips are used for various test applications. The International Electrotechnical Commission (IEC) under the guidance of Technical Committee (TC66) generated a safety standard for Test and Measurement Equipment related to test probes referenced as IEC61010-031. This standard specifies requirements for test probe tips for various test applications. For instance, the safety standard specifies the length of the exposed metal tip of the probe used in industrial applications, referred to as category III (CAT III) and category IV (CAT IV) installation, must not exceed 4 mm in length. For industrial applications (CAT III and CAT IV) where high energy exists, a probe tip of equal or less than 4 mm is important to help reduce risk of arcs and arc flash hazards.

Having a lead tip with exposed metal less than 4mm in length creates difficulties for some measurements because this would prevent a user to easily insert the probe tip into a standard wall socket for quick and accurate measurement. It is thus a problem for existing test probes that they can't meet IEC61010-31 new standard and also being capable of inserting in the electrical socket at the same time.

Traditionally, to solve this problem, there is a type of test probe with its exposed metal tip longer than 4mm with a plastic head cap for the metal tip. However, the plastic cap is removable which can't meet IEC61010-31 standard. Alternatively, in order to comply with the IEC61010-31 standard, various test probe assemblies having different probe tip lengths were used with test instruments. For instance, a user may have two sets of test probes, one probe set with probe tip lengths for testing high energy applications and another probe set with probe tip lengths for testing low energy applications. However, this resulted in the user having to manage two sets of test probes.

US patent publication No. 2010/0182027A1 discloses a test probe having an indexable probe tip and an insulative sleeve. The insulative sleeve is moveable relative to the probe tip and may be indexable to at least two positions to provide two different lengths of the probe tip exposed from the insulative sleeve. However, as clearly prescribed in IEC61010-31 A1: 2008, a retractable insulation sleeve on the test lead is not considered to provide adequate protection and thus the test probe disclosed in US2010/0182027A1 does not meet the requirement of IEC61010-31.

US patent publication No. 2010/0176828A1 discloses a reversible test probe and test probe tip. The reversible probe has a first probe tip at a first end and a second probe tip at a second end. The test probe body has an opening operable to receive the first probe tip and the second probe tip. When the first probe tip is positioned in the opening, the first probe tip is electrically coupled to a metal device in the test probe body. When the second probe tip is positioned in the opening, the second probe tip is electrically coupled to a metal device in the test probe body. However, a reversible design of the test probe significantly increases the structural complexity and cost of the test probe. The user also has to configure the test probe each time before the measurement, resulting in low operation efficiency.

### SUMMARY OF INVENTION

In the light of the foregoing background, one object of the present invention is to provide an alternate test probe that does not require separate probe tips to be carried for use on various test applications but still meet the requirement of IEC61010-31. A further, alternative, object of the invention is to provide a test probe with 4mm or less of exposed metal tip that can be inserted into a standard electrical socket. Yet a further object of the present invention is to provide a useful alternative to the current range of test probes.

One or more of the above objects is met by the combination of features of the main claim; the sub-claims disclose further advantageous embodiments of the invention.

One skilled in the art will derive from the following description other objects of the invention. Therefore, the foregoing statements of object are not exhaustive and serve merely to illustrate some of the many objects of the present invention.

Accordingly, the present invention, in one aspect, is a test probe which contains a conductive member having a first end defined by an electrically conductive tip, an insulative member surrounding a first portion of the conductive member, wherein a second potion of the conductive member between the first end and the first potion is coated with a thin layer of insulative material.

In another aspect of the present invention, the present invention discloses a test instrument which contains an output terminal and a test probe coupled to the output terminal. The test probe further contains a conductive member having a first end defined by an electrically conductive tip, an insulative member surrounding a first portion of the conductive member, wherein a second potion of the conductive member between the first end and the first potion is coated with a thin layer of insulative material.

There are many advantages to the present invention, as one of the them is that the test probe in the present invention not only complies with the safety regulation in the standard of IEC61010-31 A1: 2008, but is also adapted to be used in various applications such as being inserted into small holes like an electrical socket. The test probe only exposes a 4mm metal part. For other portion of the metal part, they are covered by a thin insulative coating such as ceramic. The very thin ceramic coating provides good insulation to meet the electrical requirement of the IEC standard with no affection to the capability of being inserted into the electrical socket.

Another advantage is that the test probe in the present invention uses very simple test lead which would not significantly increase the complexity and cost of the test probe. It is also convenient for the user to carry the whole test instrument set as there is no excess part like in the prior art. The test probe in the present invention can provide a safe (which meet IEC standard) and a convenient way of measurement (use only one test lead can test both normal condition and the electrical socket) to the user. By using the test probe, the user does not have the need to prepare a special test lead just for electrical socket.

### BRIEF DESCRIPTION OF FIGURES

The foregoing and further features of the present invention will be apparent from the following description of preferred embodiments which are provided by way of example only in connection with the accompanying figure of a test probe according to one embodiment of the present invention.

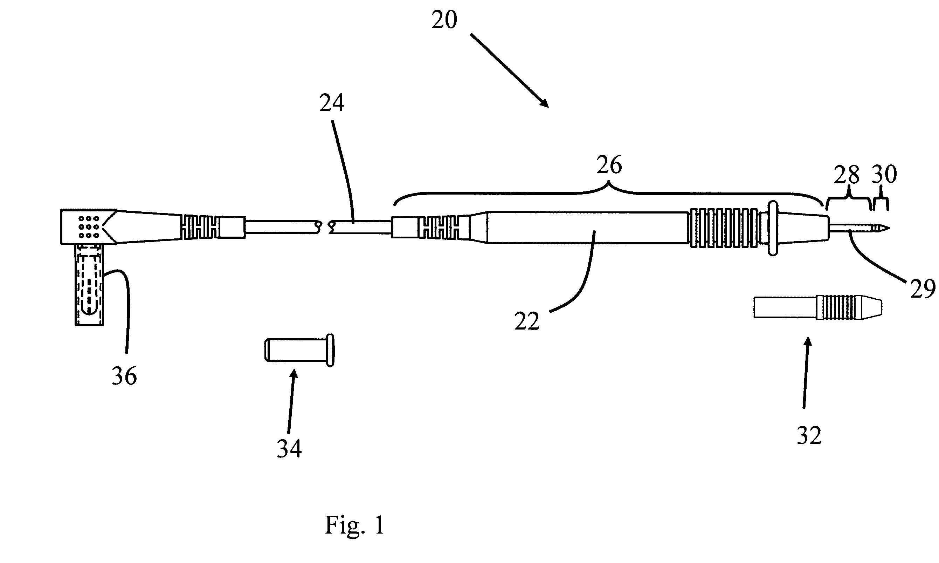

Fig. 1 illustrates the structure of a test probe according to one embodiment of the present invention.

### DETAILED DESCRIPTION OF THE PREFERRED EMBODIMENTS

In the claims which follow and in the preceding description of the invention, except where the context requires otherwise due to express language or necessary implication, the word "comprise" or variations such as "comprises" or "comprising" is used in an inclusive sense, i.e. to specify the presence of the stated features but not to preclude the presence or addition of further features in various embodiments of the invention.

As used herein and in the claims, "couple" or "connect" refers to electrical coupling or connection either directly or indirectly via one or more electrical means unless otherwise stated.

Turning now to Fig. 1, a test probe **20** for measuring electrical parameters in various electrical devices is connected to a transmission line **24** on its one end. The other end of the transmission line **24** is connected to a test instrument connector **36**. The test instrument connector **36** is configured to fit into a corresponding receptacle or output terminal on the body of a test instrument (not shown), such that the test probe **20** and the test instrument are electrically coupled. As appreciated by those skilled in the art, the test instrument connector **36** and its receptacle on the body of the test instrument could be any type of connectors, such as but not limited to shrouded or recessed banana jacks, BNC connectors, 2mm plugs or binding posts.

The test probe **20** contains an elongated conductive portion through its length, and the conductive portion has a first end **30** defining an electrically conductive tip. The conductive portion is also referred to as a conductive member. A first portion **26** of the conductive portion is surrounded by a thick plastic insulation sleeve **22**, which is also referred as an insulative member. The insulation sleeve **22** in a preferred embodiment is a non-conductive plastic sleeve, which has a sufficient length and thickness for the user to comfortably grasp the test probe for operation.

Besides the first portion **26** of the conductive portion, there is a second portion **28** of the conductive portion that is not covered by the insulation sleeve **26**. Instead, the second potion **28** of the conductive portion between the first end **30** and the first potion **26** is coated with a thin layer of insulative material **29**. In a preferred embodiment, the insulative material **29** coated on the second portion **28** is ceramic, but may be any other thin durable insulation coating. In one implementation, the coating is applied in room temperature and sintered in high temperature. In a most preferred embodiment, alumina oxide base ceramic is used for the coating. The thickness of the insulative material **29** is 10∼60µm and preferably 20∼30µm. The layer of insulative material **29** has a dielectric value high enough to prevent air discharge between two adjacent test probes when the user is testing high voltage, and is thin and durable enough to allow the test probe to be inserted into an electrical socket. The insulative material **29** is of a different material than the thick plastic insulation sleeve **22**.

The first end **30** of the conductive portion is the only part of the conductive portion that is exposed. The measurement of electrical parameters is undertaken by contacting the first end **30** to an object electric device. In a preferred embodiment, the length of the first end **30** is no more than 4mm to comply with the requirement of IEC61010-31. In a more preferred embodiment, the length of the first end **30** is 4mm.

In the embodiment described above, the test probe in the present invention has an exposed conductive part of the probe tip no more than 4mm. On the other side, since the insulative coating on the second portion **28** of the conductive portion is very thin, the diameter of the part of the test lead which includes the second portion **28** and the first end **30** is more or less the same as an exposed conductive tip. The test lead of the test probe **20** would thus be able to be inserted in a small hole such as that in an electrical socket. In comparison, in conventional technology, designs of test probes with fixed plastic sleeve which only exposure 4mm metal tip out can meet IEC 61010-31 standard, but the plastic sleeve is too thick to insert the tip into electrical socket.

In another aspect of the present invention, a test instrument equipped with a test probe as described above is also disclosed. The test instrument includes but not limited to multimeters, voltage meters, oscilloscopes and the like. The test instrument contains an output terminal on its body, and the test probe with insulative coating is connected to the output terminal.

While the invention has been illustrated and described in detail in the drawings and foregoing description, the same is to be considered as illustrative and not restrictive in character, it being understood that only exemplary embodiments have been shown and described and do not limit the scope of the invention in any manner. It can be appreciated that any of the features described herein may be used with any embodiment. The illustrative embodiments are not exclusive of each other or of other embodiments not recited herein. Accordingly, the invention also provides embodiments that comprise combinations of one or more of the illustrative embodiments described above. Modifications and variations of the invention as herein set forth can be made without departing from the spirit and scope thereof, and, therefore, only such limitations should be imposed as are indicated by the appended claims.

For example, the insulative coating on the conductive portion of the metal tip as described in a most preferred embodiment is an alumina oxide base ceramic coating. However, other types of ceramics such as magnesium oxide base, zirconium oxide base and so on can be used as well. It should be natural for one with ordinary skills in the art to adapt other kinds of insulative coating including but not limited to insulative paints, alloys, oxides or other composite materials.

The insulative sleeve described in the above embodiments is a plastic sleeve. However, other materials may also be suitable for manufacturing the insulative sleeve, such as rubber, glass or mica.

It is to be understood that, if any prior art publication is referred to herein, such reference does not constitute an admission that the publication forms a part of the common general knowledge in the art, in Australia or any other country.

## Claims

1. A test probe, comprising:
a) a conductive member having a first end defining by an electrically conductive tip;
b) an insulative member surrounding a first portion of said conductive member; and wherein a second potion of said conductive member between the first end and said first potion is coated with a layer of insulative material.

2. The test probe of claim 1, wherein the length of said first end is 4mm.

3. The test probe of claim 1, wherein said insulative member is a plastic sleeve.

4. The test probe of claim 1, wherein said insulative material is ceramic.

5. The test probe of claim 1 wherein said insulative material is of a different material than the insulative member.

6. A test instrument, comprising:
a) an output terminal;
b) a test probe coupled to the output terminal; said test probe further comprising:
i) a conductive member having a first end defined by an electrically conductive tip;
ii) an insulative member surrounding a first portion of said conductive member;
wherein a second potion of said conductive member between said first end and said first potion is coated with a layer of insulative material.

7. The test instrument of claim 6, wherein the length of said first end is 4mm.

8. The test instrument of claim 6, wherein said insulative member is a plastic sleeve.

9. The test instrument of claim 6, wherein said insulative material is ceramic.

10. The test instrument of claim 6 wherein said insulative member comprises a label portion.
